# EUROPEAN PATENT SPECIFICATION

(11) **EP 1 900 843 B1**
(45) Date of publication and mention of the grant of the patent: **08.06.2016**
(21) Application number: 06254817.7
(22) Date of filing: 15.09.2006
(51) Int. Cl.: C23C 14/06, C23C 14/02, C23C 14/16

(54) **Metal-containing diamond-like-carbon coating compositions**
Metallhaltige Schicht von diamantartigem Kohlenstoff
Revètement de carbone sous forme diamant amorphe comprenant un métal

(43) Date of publication of application: 19.03.2008
(73) Proprietor: United Technologies Corporation, Hartford, CT 06101 (US)
(72) Inventor: Cooper Clark V., Glastonbury, CT 06033 (US); Hansen Bruce D., Shelton, CT 06484 (US); Bewilogua Klaus, 38110 Braunschweig (DE)
(74) Representative: Leckey, David Herbert

(56) References cited:
- EP-A2- 1 262 674
- WO-A-01/61182
- BEWILOGUA K ET AL: "STRUCTURE, PROPERTIES AND APPLICATIONS OF DIAMOND-LIKE CARBON COATINGS PREPARED BY REACTIVE MAGNETRON SPUTTERING" ZEITSCHRIFT FUR METALLKUNDE, CARL HANSER, MUNICH, DE, vol. 96, no. 9, September 2005 (2005-09), pages 998-1004, XP001234905 ISSN: 0044-3093
- WANG ET AL: "Deposition of diamond-like carbon films containing metal elements on biomedical Ti alloys" SURFACE AND COATINGS TECHNOLOGY, ELSEVIER, AMSTERDAM, NL, vol. 200, no. 7, 21 December 2005 (2005-12-21), pages 2175-2180, XP005181179 ISSN: 0257-8972
- BARRIGA ET AL: "Tribological performance of titanium doped and pure DLC coatings combined with a synthetic bio-lubricant" WEAR, ELSEVIER SEQUOIA, LAUSANNE, CH, vol. 261, no. 1, 20 July 2006 (2006-07-20), pages 9-14, XP005508551 ISSN: 0043-1648

## Description

### BACKGROUND OF THE INVENTION

Field of Invention. The present invention relates to metal diamond-like carbon coating compositions, and more particularly, to metal diamond-like-carbon coating compositions containing an intermediate layer of a transition metal, such as chromium, or transition-metal carbide, and an exterior layer of carbon and a transition metal such as titanium, tungsten or niobium and method of making the same.

For many years, it has been known that diamond-like carbon (DLC) films are hard and have low friction coefficients (µ), especially against steel. These low µ values (-0.2) were revealed for amorphous hydrogenated (abbreviated as a-C:H or DLC) as well as for metal containing hydrocarbon (Me-C:H or Me-DLC) films. Today, for both types of coatings, several applications, above all in the field of machine elements and of tools, are known. Besides the coating properties, it is an important aspect that DLC as well as Me-DLC coatings can be deposited at low substrate temperatures (<200°C).

A comparison of DLC and Me-DLC shows that there are advantages and disadvantages to both coating materials as well as to the corresponding deposition techniques. Hard DLC coatings, consisting of a highly cross-linked network of carbon atoms, have high compressive stress (a few GPa). The mentioned high stress values often lead to poor adhesion with the substrate, especially on steel and, therefore, limit its use in practical applications.

Many methods for the preparation of DLC films have been developed. The most commonly applied method is the radio frequency (r.f.) glow discharge of hydrocarbon gases with negatively self-biased substrates. However, there are several problems in the scaling up of this r.f. technique to industrially relevant dimensions and geometries.

Commonly Me-DLC films having low metal content (atomic ratios of Me/C up to approximately 0.3) have markedly lower compressive stress than a-C:H (<1 GPa). Such films consist of a network of amorphous carbon (DLC) with incorporated metal carbides. The friction coefficients of such coatings are rather similar to those of DLC coatings. However, the wear resistance of Me-DLC coatings generally is lower than that of DLC. At one time, the lowest abrasive wear rates reported for Me-DLC coatings were at least a factor of 2 higher than those reported for metal-free DLC coatings.

Generally, Me-C:H (Me-DLC) coatings are prepared in industrial batch coaters by reactive magnetron sputtering in argon-hydrocarbon gas mixtures using metal or metal carbide targets. When comparing the two types of coatings, it should be noted that the electrical resistivity of DLC coatings (>10⁶ Ω cm) is much higher than that of Me-DLC (10⁻³ ~ 1 Ω cm).

For example, a magnetron-sputtering assisted pulsed laser deposition technique was used to prepare titanium carbide and tungsten carbide containing amorphous diamond-like carbon films in an article by Voevodin et al. In another article, Wei et al. used a pulsed laser technique with a special target configuration, which allowed to ablate graphite and a dopant (Cu, Ti, Si). A few percent of these elements incorporated into the carbon matrix caused markedly improved adhesion. However, it seems to be difficult to compare the properties of the mentioned composite films to Me-DLC films containing hydrogen and prepared using different preparation techniques as discussed in an article entitled. "Effect of target material on deposition and properties of metal-containing DLC (Me-DLC) coatings", by K. Bewilogua, C. V. Cooper, C. Specht, J. Schroder. R. Wittorf and M. Grischke, Surface & Coatings Technology 127, 224-232, Elsevier (2000), which is incorporated by reference herein in its entirety.

Consequently, there exists a need for a metal diamond-like-carbon coating compositions having a superior hardness and resistance to failure in pure rolling compared to commercially available metal diamond-like-carbon coating compositions.

BEWILOGUA K ET AL: "STRUCTURE, PROPERTIES AND APPLICATIONS OF DIAMOND-LIKE CARBON COATINGS PREPARED BY REACTIVE MAGNETRON SPUTTERING" ZEITSCHRIFT FUR METALLKUNDE, CARL HANSER, MUNICH DE, vol. 96, no. 9 (2005-09), pages 998-1004 discloses a method having the features of the preamble of claim 1.

WO 01/61182 discloses a coating for fuel injector components comprising a metal carbon material layer less than 2.0 microns thick applied to a substrate. A bond layer of chromium may be deposited between the substrate and metal carbon material layer.

WANG ET AL: "Deposition of diamond-like carbon films containing metal elements on biomedical Ti alloys" SURFACE AND COATINGS TECHNOLOGY, ELSEVIER, vol. 200, no. 7 (2005-12-21), pages 2175-2180 discloses a diamond-like carbon layer deposited on a Ti substrate. A graded metal and metal nitride interlayer is also disclosed.

BARRIGA ET AL: "Tribological performance of titanium doped and pure DLC coatings combined with a synthetic bio-lubricant" WEAR, ELSEVIER SEQUOIA, vol. 261, no. 1 (2006-07-20), pages 9-14 discloses a Ti doped DLC coating applied to a substrate. A gradual Ti interlayer is also disclosed.

EP-A-1262674 discloses a method having the faetures of the preamble of claim 1.

### SUMMARY OF THE INVENTION

In accordance with the present invention, a metal-containing diamond-like-carbon coating composition is deposited by a method as claimed in claim 1. The second layer comprises carbon and a second transition metal being tungsten, and preferably having a first surface and a second surface in contact with the first surface of the first layer. Preferably, the thickness of coating is about 0.5 micrometer to 10 micrometers. In addition, the composition can optionally possess a low abrasive wear rate. Such low abrasive wear rate should preferably not exceed more than about 1 x 10⁻¹⁰ m³m⁻¹N⁻¹. Such a coating may be deposited using substrate bias potential having a bias potential range of about -50 to -750 volts DC.

Preferably the coating has a rolling contact stress limit of at least 4 gigapascals.

It may therefore be seen that the present invention teaches a metal-containing coating having an intermediate layer comprising a transition metal and an exterior, functional layer comprising a transition metal and carbon.

The details of one or more embodiments of the invention are set forth in the accompanying drawings and the description below. Other features and advantages of the invention will be apparent from the description and drawings, and from the claims.

### BRIEF DESCRIPTION OF THE DRAWINGS

FIG. 1 is a representation of a metal diamond-like-carbon coating having an intermediate layer and an exterior layer deposited upon a substrate comprising a rolling-contact-fatigue rod;
FIG. 2 is a graph showing the relationship between metal concentration and abrasive wear rate for metal diamond-like-coating compositions containing intermediate layers of chromium and exterior layers of carbon and metals such as tungsten, titanium and niobium;
FIG. 3 is a bar graph representing the adherence performance of metal diamond-like-coatings as a function of substrate bias potential;
FIG. 4A is a representation of a rolling-contact-fatigue (RCF) experiment depicting a top view of the arrangement of three roughened balls positioned in contact with a rotating rod coated with the compositions of Samples 1-7 as described in the Examples; and
FIG. 4B is a representation of the rolling-contact-fatigue (RCF) experiment of FIG. 4A depicting a side view of the roughened balls positioned in contact with the rotating rod.

Like reference numbers and designations in the various drawings indicate like elements.

### DETAILED DESCRIPTION

Me-DLC coatings are deposited via magnetron sputtering, in which four targets composed of the metal of interest are installed into the interior of the deposition chamber, activated, and sputtered with Argon (Ar) and acetylene (C₂H₂) gases. Deposition substrates, comprising rolling-contact-fatigue rods, or substrates 10, composed of a through-hardened ferrous alloy, e.g., AISI M50, are placed into the deposition chamber and negatively biased using a direct current (DC) potential ranging from about -50 to -750 volts DC. Sputtering target compositions include elemental titanium (Ti), niobium (Nb), and tungsten (W).

Metal hydrocarbon (Me-DLC) coatings are prepared by reactive dc magnetron sputtering in unbalanced mode housing HTC 1000/4 (ABS) coater commercially available from Hauzer Techno Coating, Venlo, The Netherlands. Before initializing the deposition runs, the residual pressure in the vacuum chamber is set at less than about 10⁻³ Pascal (Pa). During the deposition runs, the total gas pressure in the vacuum chamber is between about 0.3 Pa to 0.6 Pa. The substrates mentioned herein are supported within the vacuum chamber using substrate holders maintained at temperatures up to about 200°C. These substrate holders permitted the substrate to be rotated at a rate of about twelve revolutions per minute of planetary, two-fold rotation. Throughout the entire process, the deposition rates are typically about 2 to 3 micrometers per hour.

The Me-DLC deposition process generally comprises four steps. First, the substrates are cleaned using an Argon etching process at a pressure of about 0.3 Pa as known to one of ordinary skill in the art. For this step, argon gas is admitted to the chamber until the achievement of the desired gas flow rate and/or chamber pressure, generally about 300 standard cubic centimeters per minute (sccm) and 0.3 Pa, respectively, and ionized to produce Ar+ ions for sputter cleaning the substrate surface.

Second, an intermediate layer 12 composed of a transition metal, in this case chromium (Cr), is then sputter deposited upon the Ar-ion-etched substrates. During this second stage of the deposition process, the DC current applied to one or more targets composed of chromium metal is held constant at the target value. For this process step, argon gas is introduced into the chamber and held constant until the intermediate layer had grown to achieve its target thickness. As for the Ar-ion-etching stage, the flow rate and partial pressure of argon for this second process step are, respectively, approximately 300 sccm and 0.3-0.6 Pa, respectively. As these deposition conditions are maintained, chromium metal is sputter deposited onto the substrate surface until the achievement of a desired thickness. Typically, the deposited transition-metal intermediate layer possesses a thickness of at least about 10 nanometers (0.01 micrometers) and no more than about 2000 nanometers (2.0 micrometers) and preferably about 100 nanometers (0.1 micrometers) to 300 nanometers (0.3 micrometers).

Third, the dc current applied to the chromium metal targets is decreased until reaching zero. The mixture of reactive gases is flushed from the vacuum chamber in preparation for the sputter deposition of the exterior layer. A quantity of argon gas is again introduced into the chamber, and a quantity of acetylene gas is then introduced until the ratio of argon gas to acetylene gas is approximately 1:1 or a 50/50.mixture. Generally, the amount of acetylene gas present in the reactive gas mixture is about fifteen percent to forty-five percent by volume of the chamber.

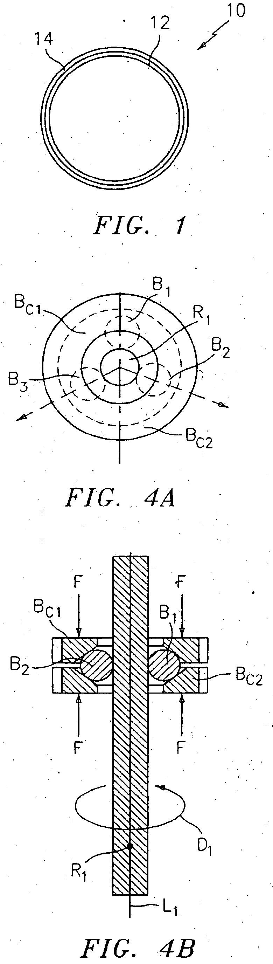

Fourth, an exterior layer 14 of the metal diamond-like-carbon coating composition is then sputter deposited upon the intermediate layer of the substrates. The DC current is applied gradually, that is, starting from zero and gradually increasing in intensity, to one or more targets composed of a metal such as tungsten, niobium, titanium and combinations thereof. Again, a quantity of argon gas is initially introduced into the chamber and then a quantity of acetylene gas is introduced until the ratio of argon gas to acetylene gas is approximately 1:1. Again, the amount of acetylene gas generally present in the mixture is about fifteen percent to forty-five percent by volume of the chamber. During the transition from pure inert gas to a combination of inert gas and acetylene or following the achievement of final acetylene-inert gas mixture, target metal begins being sputter deposited upon a first surface, that is, the exterior surface, of the intermediate layer of transition metal on each substrate until a desired thickness is achieved. These processing conditions result in the deposition of a Me-DLC coating containing an atomic metal-to-carbon (Me/C) ratio in the range of 0.1 to 0.8. For purposes of illustration and not to be taken in a limiting sense, the deposited exterior layer may possess a thickness of about 0.1 micrometer to 10 micrometers. The resulting metal-containing diamond-like-carbon coating composition deposited upon the substrate material is illustrated in FIG. 1. As depicted, a second surface, that is, the interior surface, of the exterior layer is in contact with the first surface or exterior surface of the intermediate layer whose second surface, that is, the interior surface is in contact with the exterior surface of the substrate.

### EXPERIMENTAL RESULTS

### Abrasive Wear Rate

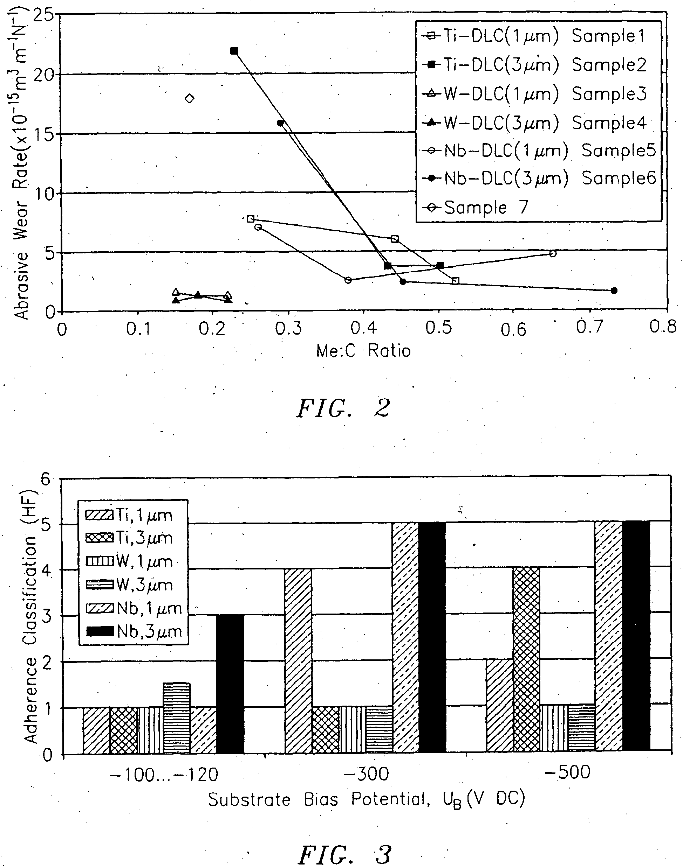

Referring now to FIG. 2, an abrasive wear rate was determined for several planar samples of substrates having various metal diamond-like-carbon coating compositions deposited thereupon in accordance with the method described herein and compared to a substrate coated with a vendor-supplied metal diamond-like-carbon coating (Balzers^{®} Balinit C^{®}).

A Calo tester operating with an aluminum oxide (Al₂O₃) and water suspension was utilized to calculate the abrasive wear rate for Samples 1-7. To quantify the results, the volume of coating removed by the Calo device, generated by a rotating ball, was divided by the normal force and the track length of the rotating ball.

Sample 1, which falls outside the scope of the claimed invention, representative of substrate 10, is a rolling-contact-fatigue rod made of AISI M50 having deposited thereupon an intermediate layer of chromium metal (Cr) having a thickness of 0.1 micrometers and an exterior layer of titanium (Ti) diamond-like-carbon composition having a thickness of 1 micrometer.

Sample 2, which falls outside the scope of the claimed invention, representative of substrate 10, is a rolling-contact-fatigue rod made of AISI M50 having deposited thereupon an intermediate layer of chromium metal (Cr) having a thickness of 0.3 micrometers and an exterior layer of titanium (Ti) diamond-like-carbon composition having a thickness of 3 micrometers.

Sample 3, representative of substrate 10, is a rolling-contact-fatigue rod made of AISI M50 having deposited thereupon an intermediate layer of chromium metal (Cr) having a thickness of 0.1 micrometers and an exterior layer of tungsten (W) diamond-like-carbon composition having a thickness of 1 micrometer.

Sample 4, representative of substrate 10, is a rolling-contact-fatigue rod made of AISI M50 having deposited thereupon an intermediate layer of chromium metal (Cr) having a thickness of 0.3 micrometers and an exterior layer of tungsten (W) diamond-like-carbon composition having a thickness of 3 micrometers.

Sample 5, which falls outside the scope of the claimed invention, representative of substrate 10, is a rolling-contact-fatigue rod made of AISI M50 having deposited thereupon an intermediate layer of chromium metal (Cr) having a thickness of 0.1 micrometers and an exterior layer of niobium (Nb) diamond-like-carbon composition having a thickness of 1 micrometer.

Sample 6, which falls outside the scope of the claimed invention, representative of substrate 10, is a rolling-contact-fatigue rod made of AISI M50 having deposited thereupon an intermediate layer of chromium metal (Cr) having a thickness of 0.3 micrometers and an exterior layer of niobium (Nb) diamond-like-carbon composition having a thickness of 3 micrometers.

Sample 7, representative of substrate 10, is a rolling-contact-fatigue rod made of AISI M50 coated with an intermediate layer of chromium metal (Cr) having a thickness of 0.3 micrometers and an exterior layer of Balinit C^{®}, from Balzers^{®}, Inc. of Elgin, Illinois, whose international headquarters is located in the Principality of Liechtenstein, a tungsten (W) diamond-like-carbon coating having a thickness of 3 micrometers, deposited using a floating potential and therefore outside the scope of the claimed invention.

The abrasive wear rate of samples 3 and 4 (W-DLC) is significantly lower than the abrasive wear rate for other compositions. The metal-to-carbon ratio of both samples 3 and 4 is much lower than for the metal-to-carbon ratios of the other samples. For the deposition of samples 3 and 4, the resulting abrasive wear rate was strongly independent of the bias potential over a range of -100 to -120 V DC, showing an abrasive wear rate of less than or equal to 1 x 10⁻¹⁵ m³m⁻¹N⁻¹. Given the metal-to-carbon ratios of about 0.1 to 0.3 and resulting high metal content, in the same range as the metal content of the Balzers^{®} Balinit C^{®} coating, the resulting W-DLC coatings of samples 3 and 4 demonstrate unexpected results in light of prior documented research by the inventors of record. Moreover, these abrasive wear rate results constitute a distinct advantage over the other compositions investigated. When compared to the standard, vendor-supplied W-DLC coating (Balzers^{®} Balinit C^{®}), samples 3 and 4 are also superior to sample 7. The abrasive wear rates of samples 3 and 4 are greater than one order of magnitude to the abrasive wear rate range of 15 ⁻²⁰ x 10⁻¹⁵ m³m⁻¹N⁻¹ measured for sample 7. As demonstrated, a Me-DLC coating, and more specifically a W-DLC coating, applied using a negative bias potential as opposed to a floating bias potential, for example, sample 7, Balinit C^{®}, from Balzers^{®}, Inc., exhibits far superior abrasive wear rate results.

### Adherence Performance

Referring now to FIG. 3, an adherence performance value was determined for Samples 1-6.

The adherence performance of the coatings was carried out by means of static Rockwell indentation at a 150 kilogram load. According to the well known VDI classification, a value of HF-1 indicates excellent adherence, and a value of HF-6 indicates complete delamination around the indentation.

Samples 3 and 4 demonstrate superior adherence over a substrate bias potential range of -100 volts to -500 volts when compared to both the Ti-containing DLC and Nb-containing DLC coatings. Moreover, the results indicate that the adherence is essentially invariant with the substrate bias potential, which is an advantage in the processing of larger parts.

Generally, as the distance from target-to-substrate increases, as may be the case for the processing of large parts, for example, the atoms sputtered from the metal targets lose kinetic energy as they traverse the distance from target to substrate. This argues in favor of applying a higher substrate bias potential when coating large parts. However, with other compositions and deposition processes parameters, the use of higher substrate bias potentials leads to coating degradation; for example, the coating adherence becomes inferior. As shown in FIG. 3, the W-DLC coatings of samples 3 and 4 do not exhibit coating degradation.

### Rolling-Contact-Fatigue

Finally, this family of W-DLC coatings exhibits a dramatic improvement in rolling-contact-fatigue (RCF) performance compared to the standard, vendor-supplied W-DLC coating (Balzers^{®} Balinit C^{®}).

A representation of an RCF experiment performed in accordance with the present invention is illustrated in FIGS. 4A and 4B. Three roughened balls (B₁, B₂, B₃); 0.5 inches (12.7 mm) in diameter, are radially loaded within a pair of bearing cups (B_{c1} and B_{c2}) against the rolling-contact-fatigue rod (R₁), 0.375 inches (9.525 mm) in diameter, of sample 1 (as described above). A clamping force (F) is applied to the bearing cups (B_{c1}, B_{c2}) causing a radial load to be applied between the roughened balls and the rod. The rod is rotated at three thousand six hundred revolutions per minute (3,600 rpm) in a direction (D₁) on its longitudinal axis (L₁) while being drip lubricated with oil conforming to MIL-L-23699, a synthetic turbine engine lubricant employed by the United States military.

Each rolling-contact-fatigue rod of samples 1-7 was subjected to 5 x 10⁶ cycles to determine the highest amount of applied contact stress, or the rolling-contact stress limit (RCSL), required to induce failure. The RCSL for the standard, vendor-supplied W-DLC coating (Balzers^{®} Balinit C^{®}) was determined to be 400 Ksi (2.76 GPa). The RCSL for the W-DLC coating was 700 Ksi (4.83 GPa). The RCSL for the Ti-DLC coating was 800 Ksi (5.52 GPa). The RCSL for the Nb-DLC coating was 400 Ksi (2.76 GPa).

When translated into a constant contact stress level of approximately 400 Ksi (2.76 GPa), it is estimated that the increase in RCSL for a W-DLC or Ti-DLC coated part would result in an increase in the rolling-contact-fatigue life of the part of between about 10 and 15 times greater than the rolling-contact-fatigue life delivered by the standard, vendor-supplied W-DLC coating (Balzers^{®} Balinit C^{®}).

Although the foregoing description of the present invention has been shown and described with reference to particular embodiments and applications thereof, it has been presented for purposes of illustration and description and is not intended to be exhaustive or to limit the invention to the particular embodiments and applications disclosed. It will be apparent to those having ordinary skill in the art that a number of changes, modifications, variations, or alterations to the invention as described herein may be made, none of which depart from the scope of the present invention. The particular embodiments and applications were chosen and described to provide the best illustration of the principles of the invention and its practical application to thereby enable one of ordinary skill in the art to utilize the invention in various embodiments and with various modifications as are suited to the particular use contemplated. All such changes, modifications, variations, and alterations should therefore be seen as being within the scope of the present invention as determined by the appended claims when interpreted in accordance with the breadth to which they are fairly, legally, and equitably entitled.

## Claims

1. A method of depositing a diamond-like-carbon coating composition having a transition-metal constituent on a substrate (10); the coating comprising:
a first layer (12) composed of a first transition metal, and having a first surface and a second surface in contact with said substrate; and
a second, Me-DLC layer (14) consisting of carbon and a second transition metal;
said first layer (12) is deposited onto said substrate using magnetron sputtering while a negatively biased DC current is applied to the substrate and held constant throughout deposition of the first layer until the first layer has reached its desired thickness; and
said second layer (14) is deposited onto said first layer (12) using magnetron sputtering while a negatively biased DC current is applied to the substrate, starting at zero and increasing in intensity during deposition; **characterised in that**:
said second layer (14) has a metal to carbon atomic ratio of about 0.1 to 0.3, **in that** said first transition metal is chromium and said second transition metal is tungsten.

2. The method according to Claim 1, wherein said second layer (14) is deposited to a thickness of about 0.5 micrometers to 10 micrometers.

3. The method according to Claim 1 or 2, wherein said first layer (12) is deposited to a thickness of about 0.01 micrometers to 2.0 micrometers.

4. The method according to any preceding Claim, wherein said second layer (14) is deposited using a substrate bias potential having a range of about -50 volts to -750 volts.

## Patentansprüche

1. Verfahren zum Abscheiden einer Schicht von diamantartigem Kohlenstoff mit einer Übergangsmetallkomponente auf ein Trägermaterial (10); wobei die Schicht Folgendes umfasst:
eine aus einem ersten Übergangsmetall bestehende erste Lage (12) mit einer ersten Oberfläche und einer zweiten Oberfläche in Kontakt mit dem Trägermaterial; und
eine zweite aus Kohlenstoff und einem zweiten Übergangsmetall bestehende Me-DLC-Lage (14);
wobei die erste Lage (12) auf dem Trägermaterial durch Magnetronsputtern abgeschieden wird, während ein negativ vorgespannter Gleichstrom an das Trägermaterial angelegt und während des Abscheidens der ersten Lage konstant gehalten wird, bis die erste Lage ihre gewünschte Dicke erreicht hat; und
die zweite Lage (14) auf die erste Lage (12) durch Magnetronsputtern abgeschieden wird, während ein negativ vorgespannter Gleichstrom an das Trägermaterial angelegt wird, der bei null anfängt und während des Abscheidens an Intensität zunimmt; **dadurch gekennzeichnet, dass**:
die zweite Lage (14) ein atomares Metall-zu-Kohlenstoff-Verhältnis von etwa 0,1 bis 0,3 aufweist und das erste Übergangsmetall Chrom und das zweite Übergangsmetall Wolfram ist.

2. Verfahren nach Anspruch 1, wobei die zweite Lage (14) mit einer Dicke von etwa 0,5 Mikrometern bis 10 Mikrometern abgeschieden wird.

3. Verfahren nach Anspruch 1 oder 2, wobei die erste Lage (12) mit einer Dicke von etwa 0,01 Mikrometern bis 2,0 Mikrometern abgeschieden wird.

4. Verfahren nach einem der vorhergehenden Ansprüche, wobei die zweite Lage (14) unter Anwendung eines Vorspannungspotenzials des Trägermaterials in einem Bereich von etwa -50 Volt bis -750 Volt abgeschieden wird.

## Revendications

1. Procédé de dépôt d'une composition de revêtement de carbone sous forme de diamant présentant un constituant de métal de transition sur un substrat (10) ; le revêtement comprenant :
une première couche (12) composée d'un premier métal de transition, et présentant une première surface et une seconde surface en contact avec ledit substrat ; et
une seconde couche Me-DLC (14) composée de carbone et d'un second métal de transition ;
ladite première couche (12) est déposée sur ledit substrat par pulvérisation à magnétron alors qu'un courant continu à pôle négatif est appliqué sur le substrat et maintenu constant durant tout le dépôt de la première couche jusqu'à ce que la première couche ait atteint son épaisseur souhaitée ; et
ladite seconde couche (14) est déposée sur ladite première couche (12) par pulvérisation à magnétron alors qu'un courant continu à pôle négatif est appliqué sur le substrat, partant de zéro et augmentant en intensité pendant le dépôt ; **caractérisé en ce que**:
ladite seconde couche (14) présente un rapport atomique entre le métal et le carbone d'environ 0,1 à 0,3, **en ce que** ledit premier métal de transition est du chrome et ledit second métal de transition est du tungstène.

2. Procédé selon la revendication 1, dans lequel ladite seconde couche (14) est déposée en une épaisseur d'environ 0,5 micromètre à 10 micromètres.

3. Procédé selon la revendication 1 ou 2, dans lequel ladite première couche (12) est déposée en une épaisseur d'environ 0,01 micromètre à 2 micromètres.

4. Procédé selon une quelconque revendication précédente, dans lequel ladite seconde couche (14) est déposée en utilisant un potentiel de polarisation de substrat présentant une plage d'environ -50 volts à -750 volts.
